(19) Europäisches Patentamt

European Patent Office

Office européen des brevets

(11) **EP 1 691 208 A1**

(12) **EUROPEAN PATENT APPLICATION**
published in accordance with Art. 158(3) EPC

(43) Date of publication:
**16.08.2006 Bulletin 2006/33**

(51) Int Cl.:
***G01R 31/36*** (2006.01)

(21) Application number: **04792569.8**

(22) Date of filing: **19.10.2004**

(86) International application number:
**PCT/JP2004/015400**

(87) International publication number:
**WO 2005/050234 (02.06.2005 Gazette 2005/22)**

(84) Designated Contracting States:
**DE FR GB IT**

(30) Priority: **19.11.2003 JP 2003389072**

(71) Applicant: **YAZAKI CORPORATION**
**Minato-ku**
**Tokyo 108-8333 (JP)**

(72) Inventor: **ARAI, Youichi; c/o Yazaki Corporation,**
**1500,**
**Shizuoka; 4101107 (JP)**

(74) Representative: **Viering, Jentschura & Partner**
**Steinsdorfstrasse 6**
**80538 München (DE)**

(54) **SATURATION POLARIZATION ESTIMATION METHOD AND DEVICE, AND DISCHARGE-ENABLED CAPACITANCE ESTIMATION METHOD**

(57) [PROBLEM] To provide a method and an apparatus for estimating saturated polarization voltage drops, and a method for estimating residual discharge capacity of the battery in order to measure accurately the state of the battery

[MEANS FOR SOLVING PROBLEM] The steps are: measuring a discharge current and a terminal voltage at high rate discharge; finding a quadratic approximation formula expressing the polarization voltage drop corresponding to the increasing discharge current at high rate discharge according to the measured discharge current and the terminal voltage; finding a maximum polarization voltage drop and a discharge current corresponding to the maximum polarization voltage drop according to the quadratic approximation formula; computing a quotient by dividing the maximum polarization voltage drop by the discharge current corresponding to the maximum polarization voltage drop; computing a product by multiplying the quotient by the maximum current; computing a sum by adding the product to the polarization voltage drop corresponding to the maximum current according to the approximation formula; and regarding the sum as the saturated polarization voltage drop.

F I G. 3

**Description**

[TECHNICAL FIELD]This invention relates to a method and an apparatus for estimating saturated polarization voltage drops that occurs at a battery when a maximum current at high rate discharge continuously flows, and a method for estimating residual discharge capacity of the battery.

[BACKGROUND ART]

Remaining discharge capacity of a battery continuously changes. For appropriately operating a load with electric power supplied by the battery, the residual discharge capacity estimation is needed. For example, a suitable estimation of residual discharge capacity of a battery in a vehicle, although varied a little corresponding to a vehicle type, is required for the following reasons.

For example, in a conventional engine vehicle, a battery supplies electric power to a starter motor for starting an engine. If the battery cannot supply the power, the engine will not start. After the engine starts, a generator driven by the engine generates the electric power to charge the battery and operate the load. Therefore, the battery becomes a secondary source. If the generator is troubled, of course, the battery becomes an only electric source to operate the load, and becomes important.

Further, in an electric vehicle having an electric motor driven by the electric power from a battery, battery is an only source. So, if the battery cannot supply the power, the vehicle will stop.

Further, in a hybrid vehicle having a motor driven by electric power supplied from both an engine and a battery, the engine often stops and the battery alternatively supplies the electric power while the vehicle is moving. However, if the battery cannot supply the power for starting the starter motor, the engine will not start.

According to the above, the residual discharge capacity of a battery should be known for charging the battery while at least the battery can start the starter motor of the engine vehicle, or drive the electric motor of the electric vehicle. Further, the residual discharge capacity of the battery in the electric vehicle is equivalent to a remaining fuel level, and required to be known quantitatively.

Incidentally, amount of charge available in a battery is generally expressed by SOC (state of charge). On the contrary, amount of charge to operate a load is generally expressed by ADC. ADC is defined as electric charge expressed by multi-Ampere-Hour (Ah), corresponding to a difference between fully charged SOC and finally discharged SOC. Sometimes, the ADC is expressed by volume percent in which the fully charged SOC is 100 %, and the finally discharged SOC is 0%.

Incidentally, it is known that the SOC of the battery is constantly related to an open circuit voltage as an open terminal voltage of a battery in an equilibrium condition in which various polarizations owing to charge-discharge cycles are canceled. Generally, the SOC of the battery is calculated from the relationship and the measured or estimated open circuit battery (for example, see Patent Document 1). Since the SOC is expressed by ampere-hour, the continuously changed SOC is known by measuring electric current through battery terminals against time through the charge-discharge cycles.

Patent Document 1: JP-A, 2002-236157

[DISCLOSURE OF INVENTION]

[PROBLEM TO BE SOLVED BY THE INVENTION]

The SOC described above is electrical charge extracted from the battery, however, since an internal electrical resistance exists in the battery, the terminal voltage of the battery is reduced by an internal voltage drop corresponding to the discharging current and the internal resistance. Therefore, an electrical charge of the SOC in a state that the terminal voltage is less than an operable voltage for the load (end of discharge voltage) is not regarded as the electrical charge capable of operating the load.

According to the conventional ADC described above, the residual discharge capacity is simply defined as the difference between a currently available SOC and the SOC corresponding to the end of discharge voltage. Therefore, although the dischargeable capacity remains in the battery according to the ADC, when the load is actually tried to be driven, the load may not be driven. Therefore, there is a problem that the conventional ADC may not accurately measure the state of the battery.

Accordingly, an object of the present invention is to provide a method and an apparatus for estimating saturated polarization voltage drops, and a method for estimating residual discharge capacity of the battery in order to measure accurately the state of the battery.

[MEANS FOR SOLVING PROBLEM]

According to the present invention as claimed in claim 1, there is provided a method for estimating a saturated polarization voltage drop that occurs at a battery when a maximum current continuously flows at high rate discharge, characterized by the steps of: measuring a discharge current and a terminal voltage at high rate discharge; finding an approximation formula expressing the polarization voltage drop corresponding to the increasing discharge current at high rate discharge according to the measured discharge current and the terminal voltage; finding a maximum polarization voltage drop and a discharge current corresponding to the maximum polarization voltage drop according to the approximation formula; computing a quotient by dividing the maximum polarization voltage drop by the discharge current corresponding to the maximum polarization voltage drop; computing a product by multiplying the quotient by the maximum current; computing a sum by adding the product to the polarization voltage drop corresponding to the maximum current according to the approximation formula; and regarding the sum as the saturated polarization voltage drop.

According to claim 1, firstly, the discharge current and the terminal voltage at high rate discharge are measured. According to the discharge current and the terminal voltage, the approximation formula expressing the polarization voltage drop corresponding to the increasing discharge current at high rate discharge is found. The maximum polarization voltage drop and the discharge current corresponding to the maximum polarization voltage drop are found according to the approximation formula. The quotient of dividing the maximum polarization voltage drop by the discharge current corresponding to the maximum polarization voltage drop is multiplied by the maximum current. Then, The product is added to the maximum polarization voltage drop corresponding to the maximum current according to the approximation formula. The sum is regarded as the saturated polarization voltage drop. Therefore, according to the measured discharge current and the measured terminal voltage, the saturated polarization voltage drop that occurs when the maximum current continuously flows, and is useful when measuring the maximum capacity which cannot be discharged because of polarization can be found.

According to the present invention as claimed in claim 2, there is provided the method for estimating the saturated polarization voltage drop as claimed in claim 1, characterized by the steps of finding an approximation formula expressing the terminal voltage corresponding to the increasing discharge current at high rate discharge according to the measured discharge current and the measured terminal voltage; making an approximation formula expressing the polarization voltage drop corresponding to the increasing discharge current at high rate discharge by subtracting a voltage drop owing to pure resistance of the battery from the approximation formula expressing the terminal voltage.

According to claim 2, the approximation formula expressing the terminal voltage corresponding to the increasing discharge current at high rate discharge is found according to the measured discharge current and the measured terminal voltage. An approximation formula expressing the polarization voltage drop corresponding to the increasing discharge current at high rate discharge is made by subtracting a voltage drop owing to pure resistance of the battery from the approximation formula expressing the terminal voltage. Therefore, according to the measured discharge current and the measured terminal voltage, the approximation formula expressing the polarization voltage drop in the increasing current at high rate discharge can be found.

According to the present invention as claimed in claim 3, there is provided an apparatus for estimating saturated polarization voltage drops that occurs at a battery when a maximum current at high rate discharge continuously flows, said apparatus including: a measuring device for measuring the discharge current and the terminal voltage at high rate discharge; a finding device for finding an approximation formula expressing the polarization voltage drop corresponding to the increasing discharge current according to the measured discharge current and the measured terminal voltage; and an estimating device for estimating the saturated polarization voltage drop by the steps of: finding a maximum polarization voltage drop and a discharge current corresponding to the maximum polarization voltage drop according to the approximation formula; computing a quotient by dividing the maximum polarization voltage drop by the discharge current corresponding to the maximum polarization voltage drop; computing a product by multiplying the quotient by the maximum current; computing a sum by adding the product to the polarization voltage drop corresponding to the maximum current according to the approximation formula; and regarding the sum as the saturated polarization voltage drop.

According to claim 3, the measuring device measures the discharge current and the terminal voltage at high rate discharge. The finding device find the approximation formula expressing the polarization voltage drop corresponding to the increasing discharge current according to the measured discharge current and the measured terminal voltage. The estimating device finds the maximum polarization voltage drop and the discharge current corresponding to the maximum polarization voltage drop according to the approximation formula, divides the maximum polarization voltage drop by the discharge current corresponding to the maximum polarization voltage drop, multiplies the quotient by the maximum current, adds the product to the polarization voltage drop corresponding to the maximum current according to the approximation formula, and regards the sum as the saturated polarization voltage drop. Therefore, the saturated polarization voltage drop that is useful when measuring the maximum capacity, which cannot be discharged because of polarization, can be found.

Therefore, according to the measured discharge current and the measured terminal voltage, the saturated polarization voltage drop that occurs when the maximum current continuously flows, and is useful when measuring the maximum capacity which cannot be discharged because of polarization can be found.

According to the present invention as claimed in claim 4, there is provided a method for estimating residual discharge capacity of a battery including the step of estimating the residual discharge capacity for allowing the maximum current to continuously flow according to the difference between an open circuit voltage at the beginning of high rate discharge, and a voltage drop owing to internal resistance including the saturated polarization voltage drop estimated by the method according to claims 1 and 2.

According to claim 4, the method estimates the residual discharge capacity according to the difference between an open circuit voltage at the beginning of high rate discharge, and a voltage drop owing to internal resistance including the saturated polarization voltage drop estimated by the method according to claims 1 and 2. Therefore, according to the estimated residual discharge capacity, the battery can be precisely judged whether a load which requires the maximum current can be surely driven or not.

[EFFECT OF THE PRESENT INVENTION]

According to claims 1 and 3 as above described, the saturated polarization voltage drop that occurs at a battery when a maximum current continuously flows at high rate discharge, and is useful when measuring the maximum capacity which cannot be discharged because of polarization can be found.

According to claim 2, according to the measured discharge current and the measured terminal voltage, the approximation formula expressing the polarization voltage drop in the increasing current at high rate discharge can be found. Therefore, a method for estimating saturated polarization voltage drops that can find more precisely the saturated polarization voltage drop can be attained.

According to claim 4, according to the estimated residual discharge capacity, the battery can be precisely judged whether a load which requires the maximum current can be surely driven or not. Therefore, a method for estimating residual discharge capacity that can measure more precisely the state of the battery can be attained.

[BRIEF DESCRIPTION OF THE DRAWINGS]

[Fig. 1] A graph showing a relation between a discharge current I and a terminal voltage V of a battery, which is measured at high rate discharge.
[Fig. 2] A graph for explaining a breakdown of voltage drops of the battery owing to discharge.
[Fig. 3] A graph for explaining a method for estimating a saturated polarization voltage drop.
[Fig. 4] A block diagram showing an apparatus for estimating residual discharge capacity having an estimating device for the saturated polarization voltage drop of the battery according to an embodiment of the present invention.
[Fig. 5] A flow chart showing the steps processed by a microcomputer 23a in Fig. 4

[EXPLANATIONS OF LETTERS OR NUMERALS]

23a microcomputer (measuring device, finding device for an approximation formula, finding device)

[BEST MODE FOR CARRYING OUT THE INVENTION]

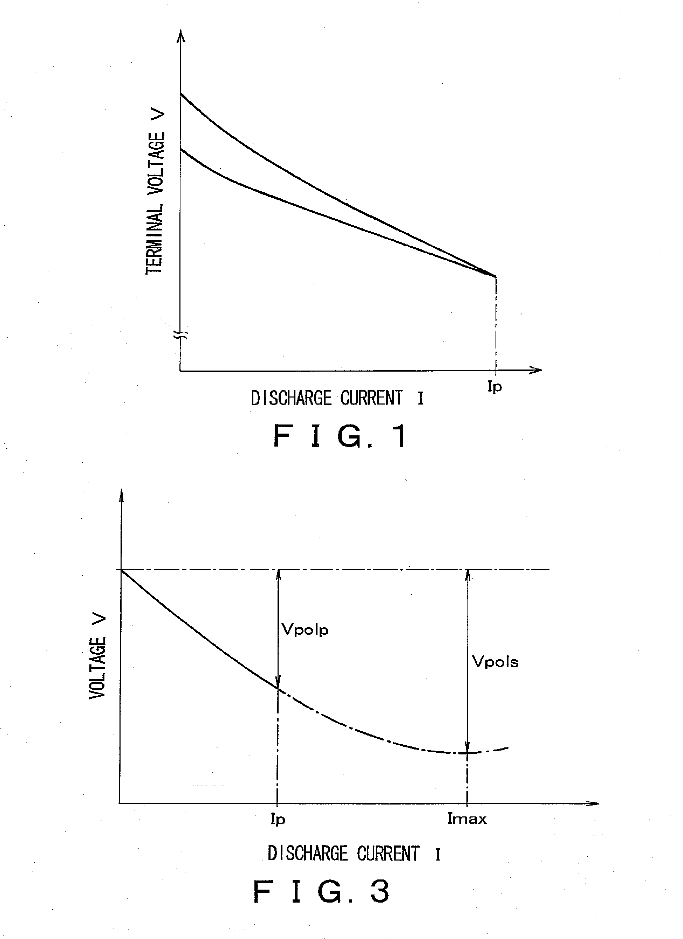

Hereunder, a method, an apparatus for estimating saturated polarization voltage drops, and a method for estimating residual discharge capacity will be explained with reference to figures. First, a concept of the present invention will be explained with reference to Figs. 1 to 3.

Generally, a terminal voltage of the battery reflects a charging state. The terminal voltages of balanced or unbalanced batteries are different. It is also known that the terminal voltage reflects a voltage drop owing to an internal resistance of the battery and discharge current from the battery.

For example, in a vehicle, discharge is occurred through a starter motor when an engine starts. At this time, so-called rush current flows. The rush current increases in a short time to a large current being enormously larger than steady-state current and decreases to the steady-current in a short time. The short time is the time that allows high coefficient of correlation between the discharge current and a growth rate of the polarization. The large current is a current that allows a reliable measurement of the growth rate of the polarization in view of voltage and current measurement accuracy. Concretely, in a case of a lead acid battery, the standard short time is, for example, less than 400 millisecond, and the standard maximum current is, for example, 3 ampere or more. Generally, such a discharge is called as high rate discharge. By measuring the discharge current and the battery terminal voltage at high rate discharge, a change of the terminal voltage corresponding to a change of the discharge current in a wide extent of zero to the maximum current can be measured. Therefore, a graph shown in Fig. 1 is attained by plotting data pair of the discharge current and the battery terminal voltage at high rate discharge by high-speed sampling, in which the discharge current corresponds to a horizontal value, and the terminal voltage corresponds to a vertical value.

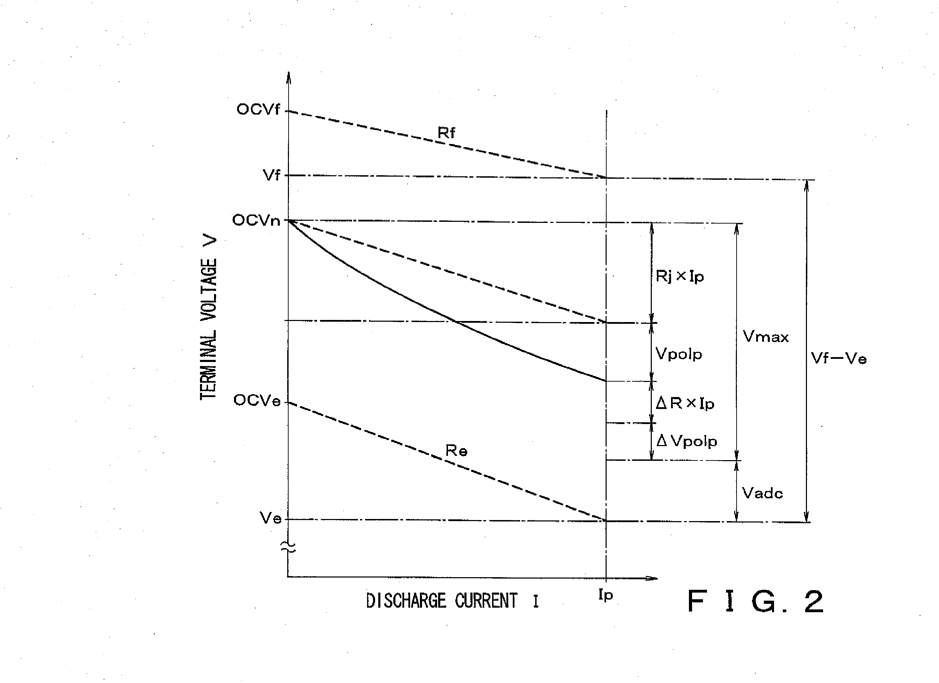

It is very important for monitoring the state of battery whether the battery can continuously provide a maximum current Ip at high rate discharge or not. Accordingly, with reference to Fig. 2, the voltage drop of the battery at the maximum current Ip will be examined.

First, the voltage drop at the maximum current Ip includes a voltage drop (Rj * Ip) caused by the maximum current Ip flowing through an internal pure resistance (ohmic resistance) Rj. The internal pure resistance Rj can be estimated by, for example, analyzing the data pair sampled at high rate discharge. A concrete method for estimating the internal pure resistance Rj is omitted here. The estimated internal pure resistance Rj includes an increment owing to the state of the battery, namely, the increment corresponding to a decrement of SOC, and a variation owing to the temperature and deterioration.

A maximum voltage increment of the pure resistance is a difference between a pure resistance at full charge Rf and a pure resistance at full discharge Re that are already-known values decided by a design specification.

$$\Delta R = Re - Rf$$

Accordingly, if the discharge at the maximum current Ip is maintained, the voltage drop owing to the internal pure resistance is possibly increased by $\Delta R * Ip$ at the maximum.

Other voltage drop except that (Rj * Ip) owing to the pure resistance Rj is a voltage drop Vpolp owing to polarization occurred in the battery. Incidentally, according to a document "a cell as a function of operative current" in "Handbook of batteries" by David Linden et al. page 10, Fig 2. 1, when a certain amount of electric current flows, a saturated voltage drop owing to polarization corresponding to the amount of the current occurs.

Because the high rate discharge is a shot time discharge, it is considered that the voltage drop Vpolp except the voltage drop (Rj * Ip) owing to the pure resistance Rj is not saturated. Therefore, when the maximum current Ip continuously flows, the voltage drop owing to the polarization is increased by $\Delta$Vpolp from Vpolp, then saturated to be a saturated polarization voltage drop (= Vpolp + $\Delta$Vpolp).

Resultingly, a total voltage drop (Vmax) as a maximum voltage drop generated in the battery while the maximum electric current flows continuously is estimated by adding the voltage drop (Rj * Ip) owing to the internal resistance component Rj, the increment (AR * Ip) of the maximum voltage drop owing to resistance component, and the saturated polarized voltage (Vpolp + $\Delta$Vpolp). Such an occurrence of voltage drop in a battery reduces the residual discharge capacity of the battery.

Therefore, Vadc found by subtracting the total voltage Vmax and end of discharge voltage (Ve = OCVe - Re * Ip, here OCVe is an open circuit voltage at the end of discharge) from an open circuit voltage OCVn before the beginning of the discharge is an indicator of a current residual discharge capacity.

$$Vadc = OCVn - Vmax - Ve \qquad (1)$$

On the other hand, a differential voltage (Vf - Ve) between a full charge voltage (Vf = OCVf - Rf * Ip, here OCVF is an open circuit voltage at full charge) and the end of discharge voltage Ve indicates the residual discharge capacity at full charge having no deterioration. Here, ADC (%) is defined as a ratio of Vadc to the differential voltage (Vf - Ve).

$$ADC (\%) = \{Vadc / (Vf - Ve)\} * 100 \qquad (2)$$

ADC (Ah) can be found by multiplying ADC (%) by K, which is a difference between a current time product corresponding to the full charge voltage Vf and a current time product corresponding to the end of discharge voltage Ve.

$$ADC (Ah) = ADC (\%) * K \qquad (3)$$

Next, a method for estimating the polarization voltage drop according to the data pair measured by high speed sampling of the discharge current and the battery terminal voltage at high rate discharge will be explained. First, a quadratic approximation formula is found by, for example, using a least-square method on the data pair collected by the high-speed sampling.

Then, a quadratic approximation formula of the polarization voltage drop is found by subtracting the voltage drop (Rj * I) owing to the pure resistance from the found quadratic approximation formula. Now, the quadratic approximation formula of the polarization voltage drop is defined as below.

$$V = a * I^2 + b * I + c \qquad (4)$$

Accordingly, the polarization voltage drop Vpolp (see Fig. 2) occurred at the maximum current Ip is defined as below.

$$Vpolp = a * Ip^2 + b * Ip + c \qquad (5)$$

As described the above, because the high rate discharge is a short time discharge, the polarization voltage drop Vpolp is considered not to be saturated. Therefore, if the maximum current Ip continuously flows, the polarization voltage drop is increased from Vpolp, and then saturated. In other words, if the maximum current Ip continuously flows, a resistance owing to the polarization is increased from a resistance (Rp = Vpolp / Ip), and then saturated. Therefore, the saturated polarization voltage drop (Vpolp + ΔVpolp) is found by finding the resistance increment owing to the polarization.

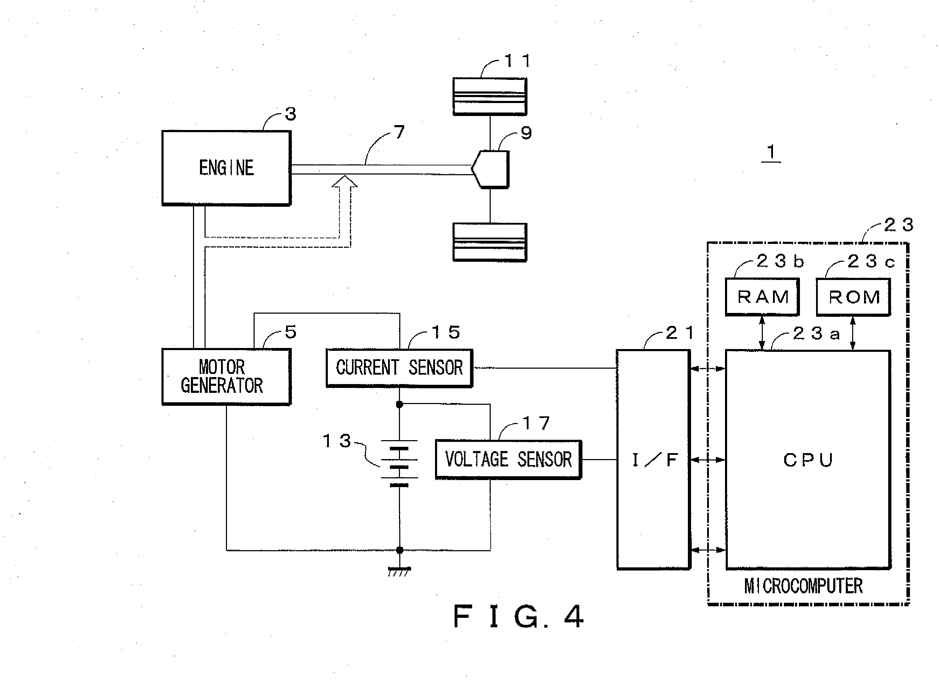

Next, a method for finding a resistance increment owing to the polarization will be explained. First, Fig. 3 shows a graph of the quadratic approximation formula (4) where the horizontal axis corresponds to the discharge current I, and the vertical axis corresponds to the terminal voltage V In Fig. 3, measured data till the maximum current Ip is drawn by the solid line, while estimated data more than the maximum current Ip is drawn by the dashed dotted line. As shown in Fig. 3, in the quadratic approximation formula, the polarization voltage drop indicates the maximum voltage Vpols at the discharge current Imax. When the current is increased more than the discharge current Imax, the polarization voltage drop is not increased more than Vpols.

A polarization resistance Rs (= Vpols / Imax) at the discharge current Imax is experimentally found to correspond to the resistance increment owing to polarization. Therefore, the saturated polarization voltage drop (Vpolp + ΔVpolp) at the maximum current Ip can be found by a formula (6) as below.

$$Vpolp + \Delta Vpolp = Vpolp + Rs * Ip = Vpolp + (Vpols / Imax) * Ip \qquad (6)$$

Next, a method for finding the discharge current Imax and the voltage drop Vpols will be explained. First, a voltage drop per unit current owing to the polarization ΔV / ΔI is found by differentiating the formula (4).

$$\Delta V / \Delta I = 2 * a * I + b \qquad (7)$$

A saturation point is a point where ΔV / ΔI = 0, and that is a maximum value of the quadratic approximation formula (4).

$$0 = 2 * a * Imax * b \qquad (8)$$

The formula (8) is arranged as below.

$$Imax = -b / 2a \qquad (9)$$

Therefore, the Vpols can be found by substitution of the discharge current Imax into the formula (4).

$$
\begin{aligned}
Vpols \quad &= a * Imax^2 + b * Imax + c \\
&= a* (-b / 2 * a)^2 + b * (-b / 2 * a) + c \\
&= b^2 / 4 * a - b^2 / 2 * a + c \qquad (10)
\end{aligned}
$$

Fig. 4 is a block diagram showing an embodiment of an apparatus for estimating residual discharge capacity embedding a device for estimating saturated polarization voltage of a battery according to the present invention. The apparatus for estimating residual discharge capacity is an apparatus for finding the saturated polarization voltage and the residual discharge capacity by implementing the methods for finding the saturated polarization voltage and for finding the residual discharge capacity according to the invention. An apparatus indicated by an item 1 in Fig. 4 is mounted on a hybrid vehicle, which includes a motor generator 5 in addition to an engine 3.

In the hybrid vehicle, normally only an engine output is transmitted through a driving shaft 7 and a differential case 9 to wheels 11. When driving a heavy load, the motor generator 5 works as a motor with electricity supplied by a battery 13. Then, an assisting output of the motor generator 5 and an output from the engine 3 are transmitted through the driving shaft 7 to the wheels.

In the hybrid vehicle, the motor generator 5 works as a generator when decelerating or braking to convert kinetic energy into electric energy for charging the battery 13.

Incidentally, in a vehicle, when an ignition switch or an accessory switch is on, a discharge current flows through the battery for supplying electricity to loads to be on. The motor generator 5 also works as a motor starter that compulsory rotates a flywheel of the engine 3 when a not-shown starter switch is on and starts the engine 3. In this case, a large rush current flows in a short time.

The engine is started by the motor generator 5 owing to the on-state starter switch, then as a not-shown ignition key is released, the starter switch turns off, and ignition switch turns on, the discharge current from the battery 13 shifts to the steady-state current corresponding to the load.

Getting back to the explanation of components, the apparatus 1 of the first embodiment includes: a current sensor 15 for detecting the discharge current I of the battery 13 for the motor generator 5 and accessories and a charge current supplied by the motor generator 5 to the battery 13; and a voltage sensor 17 having an about 1 megohm resistor connected parallel to the battery 13 for detecting a terminal voltage V of the battery 13.

The apparatus 1 further includes a microcomputer 23 collecting outputs of the current sensor 15 and the voltage sensor 17 A/D converted through an interface circuit (I/F) 21.

The microcomputer 23 includes a CPU 23a, a RAM 23b, and a ROM 23c. The RAM 23b, the ROM 23c, and the I/Fig. 21 are connected to the CPU 23a. The not-shown starter switch, the ignition switch, the accessory switch, switches of the components (loads) except the motor generator 5, and the like are also connected to the CPU 23a.

The RAM 23b includes a data area for storing various data, and working area for various operations. The RAM 23b receives a control program for the CPU 23a.

Incidentally, current and voltage values as outputs of the current sensor 15 and the voltage sensor 17 are high speed sampled in a short time period, then fetched by the CPU 23a through the interface 21. The fetched current and voltage values are used for various operations.

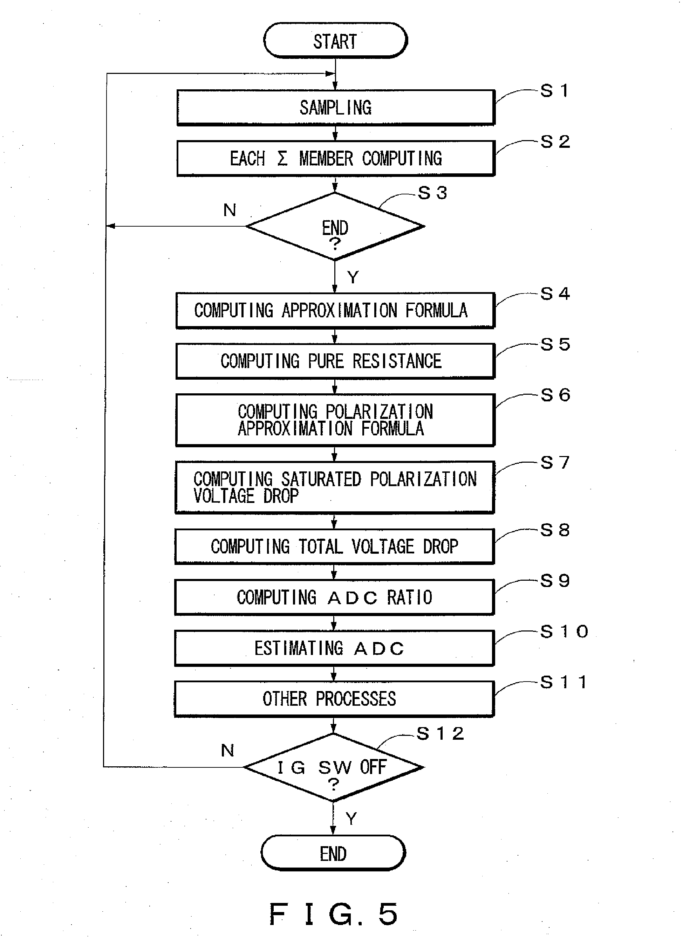

Next, operations processed by the CPU 23a according to the control program stored in the ROM 23c will be explained with reference to a flow chart in Fig. 5.

The ignition switch (IG) is on, the battery 13 supplies electricity to the microcomputer 23, and the microcomputer 23 starts the program, then, the CPU 23a gets the current sensor 15 and the voltage sensor 17 to sample the discharge current and the terminal voltage in a relatively long sampling period (Step S1). Then, the CPU 23a monitors whether the sampled discharge current I is more than a predetermined value or not. When the discharge current is more than the predetermined value, the CPU 23a judges that the rush current occurs. Then, the CPU 23a works as a measuring device, and changes the sampling period to a short time period, for example, 100 microsecond. Then, the step goes to the next (Step S2), in which a quadratic approximation of the terminal voltage corresponding to the discharge current I is found.

Incidentally, the quadratic approximated curve is found by the least squares method. For finding the quadratic approximated curve in the increasing current, each Σ member is computed according to the sampled discharge current I and the terminal voltage V When the sampled values are continuously decreased at "n" times, it is judged that the discharge current I is turned to be decreased from a peak value. Then, according to the sampled discharge current I and the sampled terminal voltage V, each Σ member is computed for finding the quadratic approximation formula at the current decrease. Then, the CPU 23a monitors whether the sampled discharge current I is less than a predetermined value or not. When the discharge current is less than the predetermined value, the CPU 23a judges that the rush current ends. Then, the CPU 23a ends the operation for finding the quadratic approximation formula (step S3). Then, the CPU 23a respectively computes the approximation formulas at the current increase using each Σ member at the current increase, and at the current decrease using each E member at the current decrease (step S4).

The CPU 23a operates for finding the pure resistance of the battery using the quadratic approximation formulas (step S5). In the operation, if the computed quadratic approximation formula includes a voltage drop owing to density polarization, corrected quadratic approximation formulas are computed by eliminating the voltage drop owing to the density polarization. Then, differential values at the maximum current Ip of two corrected quadratic approximation formulas at the current increase and decrease are calculated. Then, the pure resistance of the battery is computed as the center of the two differential values. Then, for using in various ways, the pure resistance of the battery is stored in the RAM 23b.

There are two ways for finding the center of the differential values corresponding to ways of the rush currents. When time periods of the increase and decrease of the rush currents are substantially the same, the pure resistance Rj is computed as an additional average value. On the contrary, when the time periods of the increase and decrease of the rush currents are quite different, the pure resistance is computed as an additional value attained by adding a value attained by multiplying the differential value at the peak of the corrected quadratic approximation formula of the increasing discharge current by a ratio of a time period when the increasing discharge current flows to a total time period of the charge current, and a value attained by multiplying the differential value at the peak of the corrected quadratic approximation formula of the decreasing discharge current by a ratio of a time period when the decreasing discharge current flows to a total time period of the charge current.

Next, an approximation formula of the voltage drop caused by other factors except the pure resistance at the current increase, namely, a quadratic approximation formula indicating the polarization voltage drop corresponding to the increasing discharge current at high rate discharge (hereunder referred to as "polarization approximation formula") is found by subtracting the voltage drop owing to the pure resistance Rj computed in step S5 from the approximation formula at the current increase computed in step S4 (step S6). Thus, the CPU 23a works as the finding means for an approximation formula. The pure resistance Rj computed in the step S5 and the polarization approximation formula computed in step S6 are used for finding the saturated polarization voltage drop in step S7, that is a step for estimating the saturated polarization voltage drop.

In step S7 as a step for estimating the saturated polarization voltage drop, the CPU 23a works as an estimating device, and differentiates the polarization approximation formula computed in step S6 to find the maximum polarization voltage drop Vpols in the polarization approximation formula, and the discharge current Imax corresponding to the maximum polarization voltage drop. Next, the CPU 23a substitutes the maximum current Ip into the polarization approximation formula to find the polarization voltage drop Vpolp corresponding to the maximum current Ip, then executes the formula (6) to compute the saturated polarization voltage drop (Vpolp + ΔVpolp). Then, the process goes to step S8.

In step S8 as a total voltage drop estimating process, the total voltage drop is estimated by adding the voltage drop (Rj * Ip) owing to the pure resistance Rj of the battery computed in step S5, the voltage drop (ΔR * Ip) owing to the maximum increment of the pure resistance varied corresponding to the state of the battery, and the voltage drop (Vpolp + ΔVpolp) as the maximum voltage drop owing to the polarization occurred by the maximum current Ip.

After the maximum voltage drop is computed in step S8, ADC ratio is computed using the formula (2) in step S9. After the ADC (%) is computed in step S9, ADC (Ah) is estimated using the formula (3) in step S10.

The ADC (Ah) estimated at the step S10, namely, the residual discharge capacity when the maximum current Ip continuously flows at high rate discharge is used in other processes (step S11). In the other processes, for example, when a vehicle is stopped in a start and stop system ("idling stop"), the ADC is used as a standard to judge whether the battery can restart the engine or not. In addition, the processes shown in Fig. 5 are repeated as long as the ignition switch is on (step S12).

**Claims**

1. A method for estimating a saturated polarization voltage drop that occurs at a battery when a maximum current continuously flows at high rate discharge, **characterized by** the steps of: measuring a discharge current and a terminal voltage at high rate discharge; finding an approximation formula expressing the polarization voltage drop corresponding to the increasing discharge current at high rate discharge according to the measured discharge current and the terminal voltage; finding a maximum polarization voltage drop and a discharge current corresponding to the maximum polarization voltage drop according to the approximation formula; computing a quotient by dividing the maximum polarization voltage drop by the discharge current corresponding to the maximum polarization voltage drop; computing a product by multiplying the quotient by the maximum current; computing a sum by adding the product to the polarization voltage drop corresponding to the maximum current according to the approximation formula; and regarding the sum as the saturated polarization voltage drop.

2. The method for estimating the saturated polarization voltage drop as claimed in claim 1, **characterized by** the steps of finding an approximation formula expressing the terminal voltage corresponding to the increasing discharge current at high rate discharge according to the measured discharge current and the measured terminal voltage; making an approximation formula expressing the polarization voltage drop corresponding to the increasing discharge current at high rate discharge by subtracting a voltage drop owing to pure resistance of the battery from the approximation formula expressing the terminal voltage.

3. An apparatus for estimating saturated polarization voltage drops that occurs at a battery when a maximum current at high rate discharge continuously flows, said apparatus including: a measuring device for measuring the discharge current and the terminal voltage at high rate discharge; a finding device for finding an approximation formula expressing the polarization voltage drop corresponding to the increasing discharge current according to the measured discharge current and the measured terminal voltage; and an estimating device for estimating the saturated polarization voltage drop by the steps of: finding a maximum polarization voltage drop and a discharge current corresponding to the maximum polarization voltage drop according to the approximation formula; computing a quotient by dividing the maximum polarization voltage drop by the discharge current corresponding to the maximum polarization voltage drop; computing a product by multiplying the quotient by the maximum current; computing a sum by adding the product to the polarization voltage drop corresponding to the maximum current according to the approximation formula; and regarding the sum as the saturated polarization voltage drop.

4. A method for estimating residual discharge capacity of a battery including the step of estimating the residual discharge capacity for allowing the maximum current to continuously flow according to the difference between an open circuit voltage at the beginning of high rate discharge, and a voltage drop owing to internal resistance including the saturated polarization voltage drop estimated by the method according to claims 1 and 2.

TERMINAL VOLTAGE V

DISCHARGE CURRENT I

Ip

# F I G. 1

VOLTAGE V

Vpolp

Vpols

Ip

Imax

DISCHARGE CURRENT I

# F I G. 3

F I G. 2

F I G. 4

EP 1 691 208 A1

START

SAMPLING — S 1

EACH Σ MEMBER COMPUTING — S 2

END ? — S 3

N

Y

COMPUTING APPROXIMATION FORMULA — S 4

COMPUTING PURE RESISTANCE — S 5

COMPUTING POLARIZATION APPROXIMATION FORMULA — S 6

COMPUTING SATURATED POLARIZATION VOLTAGE DROP — S 7

COMPUTING TOTAL VOLTAGE DROP — S 8

COMPUTING A D C RATIO — S 9

ESTIMATING A D C — S 10

OTHER PROCESSES — S 11

IG SW OFF ? — S 12

N

Y

END

F I G. 5

## INTERNATIONAL SEARCH REPORT

| International application No. |
| --- |
| PCT/JP2004/015400 |

| A. CLASSIFICATION OF SUBJECT MATTER |
| --- |
| Int.Cl⁷ G01R31/36 |

According to International Patent Classification (IPC) or to both national classification and IPC

| B. FIELDS SEARCHED |
| --- |

Minimum documentation searched (classification system followed by classification symbols)
Int.Cl⁷ G01R31/36

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

| C. DOCUMENTS CONSIDERED TO BE RELEVANT |
| --- |

| Category* | Citation of document, with indication, where appropriate, of the relevant passages | Relevant to claim No. |
| --- | --- | --- |
| A | JP 2002-249006 A (Yazaki Corp.), 03 September, 2002 (03.09.02), Full text; all drawings (Family: none) | 1-4 |

☐ Further documents are listed in the continuation of Box C.     ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 18 January, 2005 (18.01.05) | 01 February, 2005 (01.02.05) |

| Name and mailing address of the ISA/ Japanese Patent Office | Authorized officer |
| --- | --- |
| Facsimile No. | Telephone No. |

Form PCT/ISA/210 (second sheet) (January 2004)